(19) Europäisches Patentamt
European Patent Office
Office européen des brevets

(11) **EP 3 278 190 B1**

(12) **EUROPÄISCHE PATENTSCHRIFT**

(45) Veröffentlichungstag und Bekanntmachung des Hinweises auf die Patenterteilung:
**02.12.2020 Patentblatt 2020/49**

(21) Anmeldenummer: **16720702.6**

(22) Anmeldetag: **22.03.2016**

(51) Int Cl.:
*G05D 23/19* (2006.01)     *H05K 7/20* (2006.01)

(86) Internationale Anmeldenummer:
**PCT/DE2016/100136**

(87) Internationale Veröffentlichungsnummer:
**WO 2016/155701 (06.10.2016 Gazette 2016/40)**

(54) **REGELUNGSVERFAHREN FÜR EIN SCHALTSCHRANKKÜHLGERÄT**

REGULATION METHOD FOR AN ELECTRICAL ENCLOSURE COOLING DEVICE

PROCÉDÉ DE RÉGULATION POUR UN APPAREIL DE REFROIDISSEMENT D'ARMOIRE DE DISTRIBUTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.03.2015 DE 102015104843**

(43) Veröffentlichungstag der Anmeldung:
**07.02.2018 Patentblatt 2018/06**

(60) Teilanmeldung:
**20165800.2 / 3 690 594**

(73) Patentinhaber: **Rittal GmbH & Co. KG**
**35745 Herborn (DE)**

(72) Erfinder: **ROSENTHAL, Daniel**
**57072 Siegen (DE)**

(74) Vertreter: **Angerhausen, Christoph**
**Boehmert & Boehmert**
**Anwaltspartnerschaft mbB**
**Pettenkoferstrasse 22**
**80336 München (DE)**

(56) Entgegenhaltungen:
WO-A1-03/065781     DE-A1- 3 207 261
DE-A1-102010 009 776     GB-A- 2 329 012
US-A1- 2008 221 713

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung geht aus von einem Regelungsverfahren für ein Schaltschrankkühlgerät gemäß dem Oberbegriff des Anspruch 1. Ein derartiges Verfahren ist aus den GB 2 329 912 A bekannt.

Die DE 10 2012 108 110 A1 beschreibt ein weiteres Verfahren, bei dem das Schaltschrankkühlgerät einen ersten Kältemittelkreislauf mit einer Kältemaschine und einen davon getrennten zweiten Kältemittelkreislauf mit einer Heatpipe-Anordnung aufweist, wobei Umgebungsluft zur Wärmeableitung durch einen Außenkreis des Schaltschrankkühlgeräts und zu kühlende Luft aus dem Innern eines zu kühlenden Schaltschranks durch einen Innenkreis des Schaltschrankkühlgeräts geleitet wird. Eine Schaltschrankanordnung mit einem derartigen Schaltschrankkühlgerät ist beispielsweise aus der DE 10 2012 108 110 A1 bekannt.

Um solche Schaltschrankkühlgeräte energieeffizient betreiben zu können, ist es zu jedem Betriebspunkt erforderlich, aus den beiden Kältemittelkreisläufen denjenigen auszuwählen, welcher die erforderliche Kühlleistung effizienter bereitstellen kann. Dazu ist jedoch zum einen Kenntnis über den Kühlleistungsbedarf erforderlich, das heißt diejenige Kühlleistung, welche benötigt wird, um die Schaltschrankinnentemperatur auf einer Solltemperatur zu halten. Zum anderen ist es erforderlich, zu dem jeweiligen Betriebspunkt den Wirkungsgrad bzw. einen repräsentativen Energieeffizienzwert zu bestimmen, welchen der jeweilige Kältemittelkreislauf aufweist, wenn er den aktuell erforderlichen Kühlleistungsbedarf bereitstellen soll.

Bei aus dem Stand der Technik bekannten Schaltschrankkühlgeräten, welche beispielsweise allein auf dem Prinzip der Kältemaschine beruhen, ist es in Anbetracht der Unkenntnis über den Kühlleistungsbedarf und die Energieeffizienz der Kältemaschine üblich, die Kältemaschine unabhängig vom Kühlleistungsbedarf bei einer vorgegebenen Drehzahl, beispielsweise bei einer Höchstdrehzahl des Verdichters zu betreiben, bei welcher die Kältemaschine im Mittel über ihre Bauteillebensdauer ihren höchsten Wirkungsgrad haben soll. Des Weiteren wird durch den Betrieb bei einer Höchstdrehzahl des Verdichters sichergestellt, dass auch Kühlleistungsbedarfsspitzen abgefangen werden können. Im Umkehrschluss hat der Betrieb der Kältemaschine bei hohen Verdichterleistungen jedoch zur Folge, dass die Kältemaschine im Taktbetrieb betrieben werden muss, bei dem die Schaltschrankinnentemperatur eine Hysterese zwischen einer oberen und einer unteren Grenztemperatur um die Solltemperatur herum ausführt. Dies ist jedoch energetisch nachteilig, insbesondere im Vergleich zu der Idealsituation, bei der mit Hilfe der Kältemaschine gerade eine Kühlleistung bereitgestellt wird, welche mehr oder weniger genau dem Kühlleistungsbedarf entspricht.

Es ist die Aufgabe der Erfindung, ein Regelungsverfahren für ein Schaltschrankkühlgerät mit einer Kältemaschine und einer Heatpipe-Anordnung bereitzustellen, welches es erlaubt, zu jedem Betriebspunkt eine nach Energieeffizienzgesichtspunkten optimale Auswahl zwischen dem ersten und dem zweiten Kältemittelkreislauf zu ermöglichen.

Diese Aufgabe wird erfindungsgemäß durch ein Verfahren mit den Merkmalen des Anspruchs 1 gelöst. Die abhängigen Ansprüche betreffen jedoch vorteilhafte Ausführungsformen der Erfindung.

Demgemäß weist das erfindungsgemäße Verfahren die weiteren Schritte auf:

- Festlegen des Reglersteuersignals als eine Messgröße, die proportional zum jeweils aktuellen Kühlleistungsbedarf P ist, wobei der Kühlleistungsbedarf diejenige Kühlleistung ist, die erforderlich ist, um die Schaltschrankinnen-temperatur $T_i$ konstant auf der Solltemperatur zu halten;

- kontinuierlich oder periodisches Messen der Schaltschrankumgebungstemperatur $T_u$ und Bestimmen jeweils einer Energieeffizienz oder einer repräsentativen Größe für den ersten und den zweiten Kältemittelkreislauf bei den gemessenen Temperaturen $T_i$, $T_u$ und der Solltemperatur unter Verwendung von Kühlgerätekenndaten für den ersten und den zweiten Kältemittelkreislauf, für die beiden Fälle, dass der Kühlleistungsbedarf entweder mit dem ersten oder mit dem zweiten Kältemittelkreislauf bereitgestellt werden soll; und

- Auswählen und in Betrieb nehmen desjenigen der beiden Kältemittelkreisläufe, der den Kühlleistungsbedarf mit der besseren Energieeffizienz bereitstellen kann.

Der Erfindung liegt somit die Idee zugrunde, als zusätzliche Messgröße die Schaltschrankumgebungstemperatur zu bestimmen, um aus dem Temperaturpaar von Schaltschrankinnentemperatur und Schaltschaltumgebungstemperatur in Kenntnis eines geschätzten Kühlleistungsbedarfs eine optimale Auswahl zwischen den beiden Kältemittelkreisläufen zu treffen. Die Abschätzung des Kühlleistungsbedarfs beruht auf der Erkenntnis, dass der Regler Steuersignale für die Festlegung von Stellgrößen der Kältemaschine zur Ansteuerung des Schaltschrankkühlgeräts in Abhängigkeit von Solltemperatur und Schaltschrankinnentemperatur ausgibt, die eine Proportionalität zum Kühlleistungsbedarf aufweisen. Wenn der Regler beispielsweise ein Regler zur Steuerung einer Kältemaschine ist, beispielsweise ein PID-Regler, so umfasst der Regler beispielsweise zumindest eine Stellgröße für die Drehzahl der Lüfter der Kältemaschine für den Transport der Luft im Innenkreislauf bzw. im Außenkreislauf. Das Steuersignal des Reglers wird weiterhin eine Stellgröße aufweisen, welche die Verdichterdrehzahl vorgeben soll. Unter der Annahme, dass die Verdichterdrehzahl und die Lüfterdrehzahlen proportional zum Kühlleistungsbedarf sind, kann folglich aus dem Steuersignal des Reglers ein Kühlleistungsbedarf abgeleitet werden. Zur Umsetzung der Erfindung ist es nicht erforderlich, dass eine quantitativ exakte Größe für den Kühlleistungsbedarf bestimmt wird. Vielmehr ist eine Abschätzung des Kühlleistungsbedarfs ausreichend.

In Kenntnis des abgeschätzten Kühlleistungsbedarfs sowie der Temperaturdifferenz zwischen Schaltschrankinnentemperatur und Schaltschrankumgebungstemperatur kann folglich eine Abschätzung erfolgen, mit Hilfe welches der beiden Kältemittelkreisläufe der ermittelte Kühlleistungsbedarf energieeffizienter bereitgestellt werden kann.

Bei einer Ausführungsform der Erfindung ist es vorgesehen, dass die Stellgrößen, insbesondere die Lüfterdrehzahlen und die Verdichterdrehzahl, für den ersten und den zweiten Kältemittelkreislauf über die Gerätekenndaten einer bestimmten erwarteten Kühlleistung und Energieeffizienz zugeordnet sind, und wobei das in Betrieb nehmen unter Anwendung der Gerätekenndaten derart erfolgt, dass der ausgewählte Kältemittelkreislauf eine Kühlleistung erbringt, die im Wesentlichen dem Kühlleistungsbedarf entspricht.

Bei einer weiteren Ausführungsform der Erfindung ist der Regler ein PID-Regler für eine Kältemaschine, dessen Steuersignal in Abhängigkeit von der Solltemperatur und der Schaltschrankinnentemperatur $T_i$ zumindest eine Stellgröße für mindestens eine Lüfterdrehzahl für den Lufttransport durch einen Innen- oder Außenkreis des Kühlgeräts und eine Verdichterdrehzahl ausgibt.

Dabei kann vorgesehen sein, dass die Stellgrößen als proportional zum Kühlleistungsbedarf angenommen und mittels einer Übertragungsfunktion, die auch nur ein Multiplikator oder Umrechnungsfaktor sein kann, in einen Näherungswert für den Kühlleistungsbedarf übertragen werden.

Bei noch einer anderen Ausführungsform der Erfindung weist das Verfahren weiterhin das Abschätzen einer maximalen und/oder einer minimalen Kühlleistung für den ersten und/oder den zweiten Kältemittelkreislauf bei den gemessenen Temperaturen $T_i$, $T_u$ und unter Verwendung von Gerätekenndaten auf.

Die Gerätekenndaten können in einer Datenbank hinterlegt sein und die erbrachte Kühlleistung bei gegebener Schaltschrankinnentemperatur und gegebener Schaltschrankumgebungstemperatur mit einer erwarteten Energieeffizienz in Relation setzen.

Dabei kann vorgesehen sein, dass das Abschätzen der maximalen und/oder minimalen Kühlleistung für den ersten und/oder den zweiten Kältemittelkreislauf unter der Randbedingung erfolgt, dass der jeweils andere Kältemittelkreislauf die jeweilige maximale und/oder minimale Kühlleistung nicht mit einer besseren Energieeffizienz bereitstellen kann.

Der abgeschätzte Kühlleistungsbedarf kann darüber hinaus auch dazu verwendet werden, um den Taktbetrieb eines eine Kältemaschine aufweisenden Kältemittelkreislaufs zu optimieren. Dazu ist bei einer Ausführungsform der Erfindung vorgesehen, dass das Verfahren weiterhin für den Taktbetrieb der Kältemaschine das Bestimmen einer Kühlhysterese mit einer oberen und einer unteren Grenztemperatur aufweist, die um die Solltemperatur liegen, derart, dass die Abschaltzeit der Kältemaschine, während der sich die Schaltschrankinnentemperatur $T_i$ von der unteren Grenztemperatur auf die obere Grenztemperatur erwärmt, mindestens einer Mindestabschaltzeit des Verdichters zwischen aufeinander folgenden Aktivphasen entspricht, wobei sich die Abschaltzeit gemäß $t_{Ab} = \dfrac{C * \Delta T}{P}$ abschätzen

lässt, wobei C die vorgegebene, geschätzte oder experimentell ermittelte Wärmekapazität des Schaltschranks ist, der die zu kühlende Luft aufgenommen hat, $\Delta T$ die Temperaturdifferenz zwischen dem oberen und dem unteren Grenzwert ist, und P der abgeschätzte Kühlleistungsbedarf ist.

Weitere Einzelheiten der Erfindung werden anhand der nachstehenden Figuren erläutert. Dabei zeigt:

Figur 1     schematisch eine Regelschleife gemäß dem Stand der Technik;

Figur 2     schematisch eine Regelschleife, gemäß einer ersten Ausführungsform der Erfindung; und

Figur 3     schematisch eine Regelschleife gemäß einer anderen Ausführungsform der Erfindung.

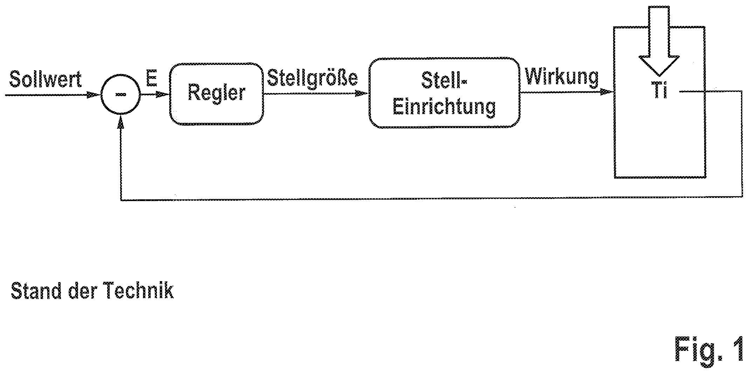

Bei der in Figur 1 dargestellten Regelschleife gemäß dem Stand der Technik wird ein Sollwert für die Schaltschrankinnentemperatur als Eingangssignal einem Regler bereitgestellt. Der Regler kann beispielsweise ein PID-Regler sein. Entsprechend der Kühltechnologie, welche zur Klimatisierung des Schaltschranks verwendet wird, ermittelt der PID-Regler, beispielsweise anhand von den Kältemittelkreislauf charakterisierenden Gerätekenndaten, Stellgrößen, die in Form eines Stellsignals an die Stelleinrichtung weitergeleitet werden. Die Stelleinrichtung kann beispielsweise eine Kältemaschine oder eine Heatpipe-Anordnung sein.

Im Falle einer Kältemaschine können die Stellgrößen beispielsweise eine Verdichterdrehzahl oder mindestens eine Lüfterdrehzahl für mindestens einen Lüfter sein. Der Verdichter und die Lüfter sind dabei hinsichtlich ihrer Drehzahl einstellbar. Anhand der dem Regler vorliegenden Gerätekenndaten bestimmt der Regler die Stellgrößen derart, dass bei gegebenen Temperatursollwert und gemessener Schaltschrankinnentemperatur $T_i$ die Stelleinrichtung so voreingestellt wird, dass sich der Differenzwert aus Sollwert und Schaltschrankinnentemperatur verkleinert. Ist die Stelleinrichtung eine Kältemaschine, so kann der Regler weiterhin darauf ausgelegt sein, die Kältemaschine in einem Taktbetrieb zu betreiben, bei der die Schaltschrankinnentemperatur eine Hysterese zwischen einem oberen und einem unteren Grenzwert um den Sollwert ausführt. Grundsätzlich erfolgt somit bei aus dem Stand der Technik bekannten Regelungsverfahren die Auswahl der Stellgrößen unabhängig von dem tatsächlichen Kühlleistungsbedarf, welcher erforderlich wäre, um die Schaltschrankinnentemperatur auf dem Sollwert zu halten.

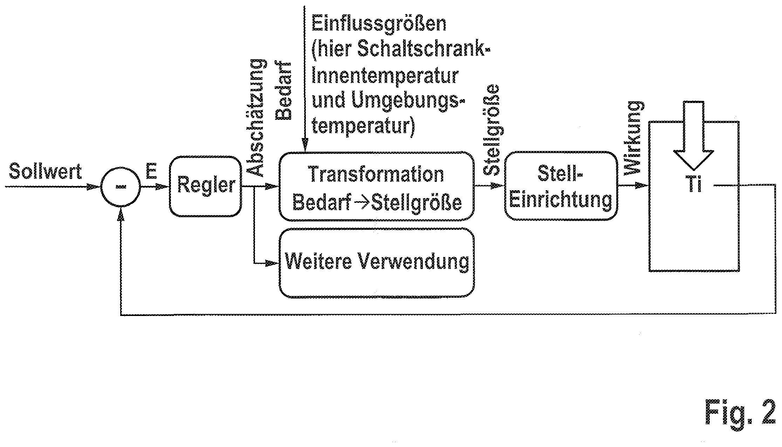

Die Figur 2 zeigt eine Regelschleife gemäß einer ersten Ausführungsform der Erfindung. Auch bei dieser wird das Differenzsignal aus Sollwert und Schaltschrankinnentemperatur $T_i$ als Eingangssignal E einem Regler zugeführt. Wie bei den aus dem Stand der Technik bekannten Regelungsverfahren kann auch der Regler bei der Ausführungsform gemäß Figur 2 ein PID-Regler sein. Erfindungswesentlich ist nunmehr, dass das Ausgangssignal des Reglers nicht unmittelbar als Stellgröße verwendet wird, welche auf die Stelleinrichtung wirkt, sondern als ein Signal interpretiert wird, das proportional zum Kühlleistungsbedarf ist. Diese Annahme ist insofern berechtigt, als dass, wie mit Bezug auf Figur 1 beschrieben, die von dem Regler ausgegebenen Stellgrößen, beispielsweise die Verdichter- oder Lüfterdrehzahlen, proportional zum Kühlleistungsbedarf sind. In Kenntnis dieses geschätzten Kühlleistungsbedarfs sowie der Temperaturdifferenz zwischen Schaltschrankinnentemperatur und Umgebungstemperatur kann beispielsweise anhand von Kühlgerätekenndaten bestimmt werden, welcher der beiden Kältemittelkreisläufe den abgeschätzten Kühlleistungsbedarf mit der höheren Energieeffizienz bereitstellen kann.

Bei der in der Figur 2 dargestellten Ausführungsform kann die Stelleinrichtung beispielsweise aus einem Schaltschrankkühlgerät bestehen, das neben einer Kältemaschine eine Heatpipe-Anordnung aufweist, die alternativ für die Bereitstellung eines Kühlleistungsbedarfs eingesetzt werden können. Je nachdem, ob die Abschätzung der Energieeffizienz von Kältemaschine und Heatpipe-Anordnung ergeben hat, dass bei den gegebenen Umständen (Kühlleistungsbedarf, Schaltschrankinnentemperatur, Schaltschrankumgebungstemperatur) die ein oder die andere Kühltechnologie den Kühlleistungsbedarf mit der besseren Energieeffizienz bereitstellen kann, wird die energieeffizientere Kühlmethode für die Kühlung der Schaltschrankluft ausgewählt, indem entsprechende Stellgrößen an die Stelleinrichtung weitergeleitet werden.

Darüber hinaus ist es denkbar, dass der abgeschätzte Kühlleistungsbedarf zur weiteren Verwendung herangezogen wird. Wie bereits oben beschrieben, kann der abgeschätzte Kühlleistungsbedarf auch dazu verwendet werden, um die Hysterese einer Kältemaschine dahingehend zu optimieren, dass die Abschaltzeit zwischen den Aktivphasen der Kältemaschine gerade einer Mindestabschaltzeit des Verdichters der Kältemaschine entspricht, welche erforderlich ist, um die dauerhafte Betriebssicherheit der Kältemaschine zu gewährleisten.

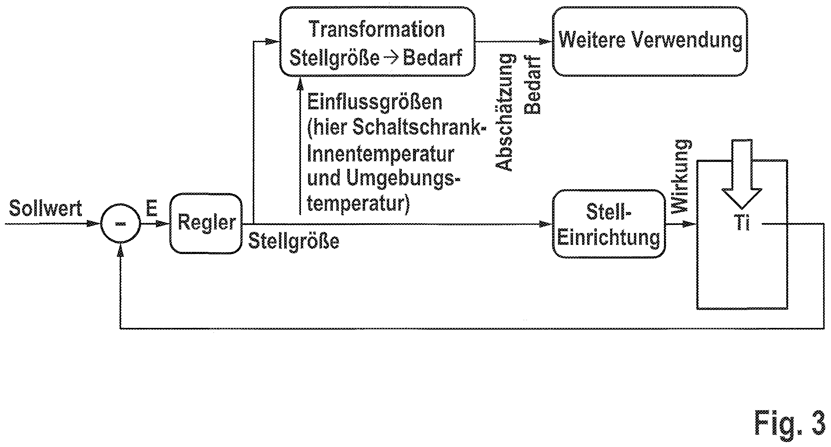

Bei der in Figur 3 dargestellten Ausführungsform entspricht die Regelschleife, soweit die Kühlung des Schaltschranks betroffen ist, derjenigen, die in Figur 1 dargestellt und aus dem Stand der Technik bekannt ist. Bei der Ausführungsform gemäß Figur 3 wird jedoch das Ausgangssignal des Reglers, nämlich die an die Stelleinrichtung ausgegebenen Stellgrößen, wiederum in der mit Bezug auf Figur 2 beschriebenen Weise zur Abschätzung des Kühlleistungsbedarfs herangezogen, wozu wiederum als weitere Einflussgrößen die Schaltschrankinnentemperatur und die Schaltschrankumgebungstemperatur mit einfließen. Dieser abgeschätzte Kühlleistungsbedarf kann auf vielfältige Weise bei der Optimierung des Schaltschrankbetriebs oder des Betriebs eines Rechenzentrums, in dem mehrere Schaltschränke angeordnet sind und das ein Energiemanagement aufweist, verwendet werden. Wie bereits erwähnt, kann mit Hilfe des abgeschätzten Kühlleistungsbedarfs beispielsweise die Hysterese einer Kältemaschine die im Taktbetrieb läuft, insoweit optimiert werden, dass die Abschaltdauer zwischen einzelnen Aktivphasen des Verdichters mindestens einer Mindestabschaltzeit des Verdichters entspricht.

## Patentansprüche

1. Regelungsverfahren für ein Schaltschrankkühlgerät, das einen ersten Kältemittelkreislauf mit einer Kältemaschine und einen davon getrennten zweiten Kältemittelkreislauf mit einer Heatpipe-Anordnung aufweist, wobei Umgebungsluft eines Schaltschranks zur Wärmeableitung durch einen Außenkreis des Schaltschrankkühlgeräts und zu kühlende Luft aus dem Innern des Schaltschranks durch einen Innenkreis des Schaltschrankkühlgeräts geleitet wird, wobei das Verfahren die Schritte aufweist:

   - kontinuierliches oder periodisches Messen einer aktuellen Schaltschrankinnen-temperatur ($T_i$) und Festlegen einer Solltemperatur für die Schaltschrankinnen-temperatur ($T_i$), wobei die aktuelle Schaltschrankinnen-temperatur ($T_i$) und die Solltemperatur Eingangssignale eines Reglers zur Ansteuerung des Schaltschrankkühlgeräts bilden, und wobei der Regler in Abhängigkeit der Eingangssignale ein Steuersignal für die Festlegung von Stellgrößen der Kältemaschine ausgibt;
   - Festlegen des Reglersteuersignals als eine Messgröße, die proportional zum jeweils aktuellen Kühlleistungsbedarf (P) ist, wobei der Kühlleistungsbedarf diejenige Kühlleistung ist, die erforderlich ist, um die Schaltschrankinnentemperatur ($T_i$) konstant auf der Solltemperatur zu halten;

   **gekennzeichnet durch** die Schritte:

   - kontinuierliches oder periodisches Messen der

Schaltschrankumgebungstemperatur ($T_u$) und Bestimmen jeweils einer Energieeffizienz oder einer repräsentativen Größe für den ersten und den zweiten Kältemittelkreislauf bei den gemessenen Temperaturen ($T_i$, $T_u$) und der Solltemperatur unter Verwendung von Kühlgerätekenndaten für den ersten und den zweiten Kältemittelkreislauf, für die beiden Fälle, dass der Kühlleistungsbedarf entweder mit dem ersten oder mit dem zweiten Kältemittelkreislauf bereitgestellt werden soll; und
- Auswählen und in Betrieb nehmen desjenigen der beiden Kältemittelkreisläufe, der den Kühlleistungsbedarf mit der besseren Energieeffizienz bereitstellen kann.

2. Verfahren nach Anspruch 1, bei dem die Stellgrößen für den ersten und den zweiten Kältemittelkreislauf über die Gerätekenndaten einer bestimmten erwarteten Kühlleistung und Energieeffizienz zugeordnet sind, und wobei das in Betrieb nehmen unter Anwendung der Gerätekenndaten derart erfolgt, dass der ausgewählte Kältemittelkreislauf eine Kühlleistung erbringt, die im Wesentlichen dem Kühlleistungsbedarf entspricht.

3. Verfahren nach Anspruch 1 oder 2, bei dem der Regler ein PID-Regler für eine Kältemaschine ist, dessen Steuersignal in Abhängigkeit von der Solltemperatur und der Schaltschrankinnentemperatur ($T_i$) zumindest eine Stellgröße für mindestens eine Lüfterdrehzahl für den Lufttransport durch einen Innen- oder Außenkreis des Kühlgeräts und eine Verdichterdrehzahl ausgibt.

4. Verfahren nach Anspruch 3 , bei dem die Stellgrößen als proportional zum Kühlleistungsbedarf angenommen und mittels einer Übertragungsfunktion, die auch nur ein Multiplikator oder Umrechnungsfaktor sein kann, in einen Näherungswert für den Kühlleistungsbedarf übertragen werden.

5. Verfahren nach einem der Ansprüche 2 bis 4, das weiterhin das Abschätzen einer maximalen und/oder einer minimalen Kühlleistung für den ersten und/oder den zweiten Kältemittelkreislauf bei den gemessenen Temperaturen ($T_i$, $T_u$) und unter Verwendung von Gerätekenndaten aufweist.

6. Verfahren nach Anspruch 5, bei dem das Abschätzen der maximalen und/oder minimalen Kühlleistung für den ersten und/oder den zweiten Kältemittelkreislauf unter Randbedingung erfolgt, dass der jeweils andere Kältemittelkreislauf die jeweilige maximale und/oder minimale Kühlleistung nicht mit einer besseren Energieeffizienz bereitstellen kann.

7. Verfahren nach einem der vorangegangenen Ansprüche, das weiterhin den Schritt aufweist:

- für den Taktbetrieb der Kältemaschine, Bestimmen einer Kühlhysterese mit einer oberen und einer unteren Grenztemperatur, die um die Solltemperatur liegen, derart, dass die Abschaltzeit der Kältemaschine, während der sich die Schaltschrankinnentemperatur ($T_i$) von der unteren Grenztemperatur auf die obere Grenztemperatur erwärmt, mindestens einer Mindestabschaltzeit des Verdichters zwischen aufeinander folgenden Aktivphasen entspricht,

wobei sich die Abschaltzeit gemäß

$$t_{Ab} = \frac{C * \Delta T}{P}$$ abschätzen lässt, wobei C die vorgegebene, geschätzte oder experimentell ermittelte Wärmekapazität des Schaltschranks ist, der die zu kühlende Luft aufgenommen hat, $\Delta T$ die Temperaturdifferenz zwischen dem oberen und dem unteren Grenzwert ist, und P der abgeschätzte Kühlleistungsbedarf ist.

## Claims

1. A control method for a switchgear cabinet refrigerating apparatus which comprises a first refrigerant circuit with a refrigerating machine and a second refrigerant circuit separate therefrom with a heat pipe arrangement, wherein ambient air of a switchgear cabinet is passed through an outer circuit of the switchgear cabinet refrigerating apparatus for heat dissipation and air to be cooled from the interior of the switchgear cabinet is passed through an inner circuit of the switchgear cabinet refrigerating apparatus, the method comprising the steps

- continuously or periodically measuring a current switch cabinet internal temperature ($T_i$) and determining a setpoint temperature for the switch cabinet internal temperature ($T_i$), wherein the current switch cabinet internal temperature ($T_i$) and the setpoint temperature form input signals of a controller for actuating the switch cabinet cooling device, and wherein the controller outputs a control signal for determining manipulated variables of the refrigerating machine as a function of the input signals;
- defining the controller control signal as a measured variable which is proportional to the respective current cooling power requirement (P), wherein the cooling power requirement is that cooling power which is required to keep the switch cabinet internal temperature ($T_i$) constantly at the setpoint temperature;

**characterized by** the steps:

- continuously or periodically measuring the switch cabinet ambient temperature ($T_u$) and determining an energy efficiency or a representative quantity for the first and the second refrigerant circuit, respectively, at the measured temperatures ($T_i$, $T_u$) and the target temperature using refrigeration equipment characteristics for the first and the second refrigerant circuit, for the two cases that the cooling power requirement is to be provided with either the first or the second refrigerant circuit; and
- selecting and commissioning the one of the two refrigerant circuits that can provide the cooling capacity requirement with the better energy efficiency.

2. The method according to claim 1, in which the control variables for the first and the second refrigerant circuit are assigned to a specific expected cooling capacity and energy efficiency by means of the device characteristics, and wherein the commissioning is carried out by using the device characteristics in such a way that the selected refrigerant circuit provides a cooling capacity which essentially corresponds to the cooling capacity requirement.

3. The method according to claim 1 or 2, in which the controller is a PID controller for a refrigerating machine, the control signal of which, depending on the setpoint temperature and the internal cabinet temperature ($T_i$), outputs at least one manipulated variable for at least one fan speed for air transport through an internal or external circuit of the refrigerating machine and one compressor speed.

4. The method according to claim 3, in which the control variables are assumed to be proportional to the cooling capacity requirement and are transferred into an approximate value for the cooling capacity requirement by means of a transfer function, which can also only be a multiplier or conversion factor.

5. The method according to one of claims 2 to 4, which further comprises estimating a maximum and/or a minimum cooling capacity for the first and/or the second refrigerant circuit at the measured temperatures ($T_i$, $T_u$) and using equipment characteristics.

6. The method according to claim 5, in which estimating the maximum and/or minimum cooling capacity for the first and/or the second refrigerant circuit takes place under the condition that the respective other refrigerant circuit cannot provide the respective maximum and/or minimum cooling capacity with a better energy efficiency.

7. The method according to one of the preceding claims, which further comprises the step

- for the cyclic operation of the refrigerating machine, determining a cooling hysteresis with an upper and a lower limit temperature which lie around the setpoint temperature in such a way that the switch-off time of the refrigerating machine, during which the switch cabinet internal temperature ($T_i$) heats up from the lower limit temperature to the upper limit temperature, corresponds at least to a minimum switch-off time of the compressor between successive active phases,
where the switch-off time can be estimated according to $t_{Ab} = \dfrac{C * \Delta T}{P}$, where C is the specified, estimated or experimentally determined heat capacity of the switch cabinet that has absorbed the air to be cooled, $\Delta T$ is the temperature difference between the upper and lower limit values, and P is the estimated cooling capacity requirement.

**Revendications**

1. Procédé de régulation pour un appareil de refroidissement d'armoire de commande, qui comprend un premier circuit de réfrigérant avec une machine frigorifique et un deuxième circuit de réfrigérant, séparé de celui-ci, avec une disposition de type tube de chauffe, dans lequel l'air environnant d'une armoire de commande est guidé, pour l'évacuation de la chaleur, à travers un circuit externe de l'appareil de refroidissement de l'armoire de commande et l'air à refroidir est guidé de l'intérieur de l'armoire de commande à travers un circuit inter de l'appareil de refroidissement de l'armoire de commande, dans lequel le procédé comprend les étapes suivantes :

- mesure continue ou périodique d'une température interne de l'armoire de commande actuelle ($T_i$) et détermination d'une température de consigne pour la température interne de l'armoire de commande actuelle ($T_i$), dans lequel la température interne de l'armoire de commande actuelle ($T_i$) et la température de consigne constituent des signaux d'entrée d'un régulateur pour le contrôle de l'appareil de refroidissement d'armoire de commande et dans lequel le régulateur délivre, en fonction des signaux d'entrée, un signal de commande pour la détermination de grandeurs de réglage de la machine frigorifique ;
- détermination du signal de contrôle du régulateur en tant que grandeur de mesure, qui est proportionnelle au besoin en puissance de refroidissement actuel (P), dans lequel le besoin en puissance de refroidissement est la puissance de refroidissement qui est nécessaire pour maintenir de manière constante la température interne de l'armoire de commande actuelle ($T_i$) à la température de consigne ;

**caractérisé par** les étapes suivantes :

- mesure continue ou périodique d'une température ambiante de l'armoire de commande ($T_u$) et détermination d'une efficience énergétique ou d'une grandeur représentative pour les premier et deuxième circuits de réfrigérant aux températures mesurées ($T_i$, $T_u$) et à la température de consigne à l'aide de données caractéristiques d'appareil de refroidissement pour les premier et deuxième circuits de réfrigérant, pour les deux cas où le besoin en puissance de refroidissement doit être mis à disposition soit avec le premier soit avec le deuxième circuit de réfrigérant ; et
- sélection et mise en service de celui des deux circuits de réfrigérant qui peut mettre à disposition le besoin en puissance de refroidissement avec la meilleure efficience énergétique.

2. Procédé selon la revendication 1, dans lequel les grandeurs de réglage pour les premier et deuxième circuits de réfrigérant correspondent, grâce aux données caractéristiques de l'appareil, à une puissance de refroidissement et à une efficience énergétique attendues déterminées et dans lequel la mise en service a lieu à l'aide des données caractéristiques de l'appareil de façon à ce que le circuit de réfrigérant sélectionné apporte une puissance de refroidissement qui correspond globalement au besoin en puissance de refroidissement.

3. Procédé selon la revendication 1 ou 2, dans lequel le régulateur est un régulateur PID pour une machine frigorifique dont le signal de contrôle délivre, en fonction de la température de consigne et de la température interne de l'armoire de commande ($T_i$), au moins une grandeur de réglage pour au moins une vitesse de rotation de ventilateur pour le transport de l'air à travers un circuit interne ou externe de l'appareil de refroidissement et une vitesse de rotation de compresseur.

4. Procédé selon la revendication 3, dans lequel les grandeurs de réglage sont supposées proportionnelles au besoin en puissance de refroidissement et sont transférées, au moyen d'une fonction de transfert, qui peut également être un simple multiplicateur ou un facteur de conversion, vers une valeur approximative pour le besoin en puissance de refroidissement.

5. Procédé selon l'une des revendications 2 à 4, qui comprend en outre l'estimation d'une puissance de refroidissement maximale et/ou minimale pour le premier et/ou le deuxième circuit de réfrigérant aux températures mesurées ($T_i$, $T_u$) et à l'aide de données caractéristiques de l'appareil.

6. Procédé selon la revendication 5, dans lequel l'estimation de la puissance de refroidissement maximale et/ou minimale pour le premier et/ou le deuxième circuit de réfrigérant a lieu selon la contrainte que l'autre circuit de réfrigérant ne puisse pas mettre à disposition la puissance de refroidissement maximale et/ou minimale avec une meilleure efficience énergétique.

7. Procédé selon l'une des revendications précédentes, qui comprend en outre l'étape suivante :

- pour le fonctionnement cadencé de la machine frigorifique, détermination d'une hystérésis de refroidissement avec des températures limites supérieure et inférieure qui se trouvent autour de la température de consigne de façon à ce que le temps d'arrêt de la machine frigorifique, pendant lequel la température interne de l'armoire de commande ($T_i$) augmente de la température limite inférieure vers la température limite supérieure, corresponde au moins à un temps d'arrêt minimum du compresseur entre des phases actives successives, dans lequel le temps d'arrêt peut être estimé

selon $t_{Ab} = \dfrac{C * \Delta T}{P}$, dans lequel C est la capacité thermique, prédéterminée, estimée ou déterminée de manière expérimentale, de l'armoire de commande qui a logé l'air à refroidir, $\Delta T$ est la différence de température entre la valeur limite supérieure et la valeur limite inférieure et P est le besoin en puissance de refroidissement estimé.

EP 3 278 190 B1

Sollwert — E → Regler → Stellgröße → Stell-Einrichtung → Wirkung → Ti

Stand der Technik

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2329912 A

- DE 102012108110 A1